# EUROPEAN PATENT APPLICATION

(11) **EP 4 498 107 A1**
(43) Date of publication of application: **29.01.2025**
(21) Application number: 23187165.8
(22) Date of filing: 24.07.2023
(51) Int. Cl.: G01R 33/34, G01R 33/341, G01R 33/54

(54) **MEDICAL SYSTEM WITH A FLEXIBLE MAGNETIC RESONANCE IMAGING COIL WITH A BEND SENSOR, A METHOD FOR OPERATING THE MEDICAL SYSTEM AND A COMPUTER PROGRAM WHICH CONTROLS THE MEDICAL SYSTEM**

(71) Applicant: Koninklijke Philips N.V., 5656 AG Eindhoven (NL)
(72) Inventor: FORTHMANN, Peter, Eindhoven (NL); LIPS, Oliver, Eindhoven (NL); VERNICKEL, Peter, 5656AG Eindhoven (NL); LEUSSLER, Christoph Günther, Eindhoven (NL); PREVRHAL, Sven Peter, Eindhoven (NL)
(74) Representative: Philips Intellectual Property & Standards

(57) **Abstract**

Disclosed herein is a medical system (100, 200, 300) comprising a flexible magnetic resonance imaging coil (102, 102'). The flexible magnetic resonance imaging coil comprises at least one flexible coil element (106); a flexible substrate (104), wherein the at least one flexible coil element is attached to the flexible substrate; and a bend sensor system (108) attached to the flexible substrate and configured to detect an over flexion condition of at least a portion of the at least one flexible coil element.

## Description

### FIELD OF THE INVENTION

The invention relates to magnetic resonance imaging, in particular to magnetic resonance imaging coils.

### BACKGROUND OF THE INVENTION

A large static magnetic field is used by Magnetic Resonance Imaging (MRI) scanners to align the nuclear spins of atoms as part of the procedure for producing images within the body of a patient. Magnetic resonance imaging systems use time varying magnetic fields and radio-frequency pulses according to a magnetic resonance imaging protocol to manipulate the orientation of these nuclear spins. Radio-frequency echoes produced by the nuclear spins are then measured using a magnetic resonance imaging coil to acquire k-space data which may then be reconstructed into a magnetic resonance image.

International patent application publication WO2020120347 discloses a radio frequency (RF) system comprises an RF-array of antenna elements, a regulating arrangement to tune the antenna elements' impedances and a camera system to acquire image information of the RF-array. An analysis module is provided to derive operational settings such as resonant tuning settings, decoupling and impedance matchings of the antenna elements' impedances from the image information. The image information also represents the actual impedances and resonant properties of the RF-array. From the image information appropriate impedance settings can be derived that are the tuning parameters to render the RF-array resonant.

### SUMMARY OF THE INVENTION

The invention provides for a medical system, a method, and a computer program, in the independent claims. Embodiments are given in the dependent claims.

In one aspect the invention provides for a medical system that comprises a flexible magnetic resonance imaging coil. The flexible magnetic resonance imaging coil comprises at least one flexible coil element. The flexible magnetic resonance imaging coil further comprises a flexible substrate. The at least one flexible coil element is attached to the flexible substrate.

Since the flexible substrate and the at least one flexible coil element are attached, as the flexible substrate or the flexible coil element is flexed or bent the other flexes or bends also. This embodiment may have benefits because if a flexible coil element is bent too much or is over flexed it may cause it to perform more poorly or to have a failure when it is used in a magnetic resonance imaging system. The bend sensor system may therefore be used to ensure that the at least one flexible coil element is functioning properly.

The flexible magnetic resonance imaging coil further comprises a bend sensor system that is attached to the flexible substrate and configured to detect an over-flexion condition or over-bend condition of at least a portion of the at least one flexible coil element.

In another aspect the invention provides for a method of operating the medical system according to an embodiment. The method comprises receiving the warning signal from detection electronics. The method further comprises performing any one of the following actions: providing an operator warning, provide a remote service center warning, disabling the acquisition of k-space data using the flexible magnetic resonance imaging coil, and combinations thereof.

In another aspect the invention provides for a computer program that comprises machine-executable instructions for execution by a processor controlling a medical system according to an embodiment. Execution of the machine-executable instructions causes the computational system to receive a warning signal from detection electronics. Execution of the machine-executable instructions further causes the computational system to perform any one of the following if the warning signal is received: provide an operator warning, provide a remote service center warning, disable the acquisition of k-space data using the flexible magnetic resonance imaging coil, and combinations thereof.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 illustrates a further example of a medical system;
Fig. 3 illustrates a further example of a medical system;
Fig. 4 shows a flow chart which illustrates a method of using the medical system of Fig. 3;
Fig. 5 illustrates an example of a capacitive bend sensor; and
Fig. 6 illustrates an example of a bend sensor embedded within the flexible substrate.

### DESCRIPTION OF EMBODIMENTS

Like numbered elements in these figures are either equivalent elements or perform the same function. Elements which have been discussed previously will not necessarily be discussed in later figures if the function is equivalent.

A flexible coil element as used herein is a magnetic resonance imaging coil element that is able to be bent or flexed.

The at least one flexible coil element is attached to the flexible substrate. The attachment to the flexible substrate may be performed in different ways. In some instances, the at least one flexible coil element is attached to a surface of the flexible substrate. In other examples the flexible substrate may be partially or even completely embedded within the flexible coil element.

In other embodiments the at least one flexible coil element could be woven into the flexible substrate.

A bend sensor system as used herein encompasses a system configured to detect the over-flexion condition using one or more sensors. For example, the bend sensor system in some examples may comprise bend sensors distributed on the flexible substrate in different locations. In other examples the bend sensor system may be a sensor which detects a bend condition over a longer stretch of distance or along an expanse. For example, a fiber optic which is bent too much can be used to detect an over-flexion condition.

In another example the medical system further comprises detection electronics. The detection electronics are configured to detect the over-flexion condition using the bend sensor system. The detection electronics are further configured to provide a warning signal if the over-flexion condition is detected. This example may be beneficial because it may provide for an efficient means to warn the user or operator or system of the over-flexion condition.

In some examples the detection electronics could be incorporated into the flexible magnetic resonance imaging coil. For example, in digital coils there is typically an electronics package which measures k-space data and digitizes it for transmission to a magnetic resonance imaging system. In these cases the detection electronics could be incorporated into the electronics for the digital coil. In other examples, the detection electronics may be separate from the flexible magnetic resonance imaging coil. For example, in an analogue coil there are typically transmission lines that are attached to the magnetic resonance imaging coil going to a transmitter and/or receiver. The connector, which is attached to the flexible magnetic resonance imaging coil, may contain the detection electronics in this example. In other examples the detection electronics may be built into the transmitter and/or receiver. For example, if the bend sensor system is a fiber optic then the connector for the analogue coil may provide optical connections to the bend sensor system or fiber optic for detecting the over-flexion condition. Likewise, optical sensors and detectors could also be included into the connector for the flexible magnetic resonance imaging coil when it is an analogue coil.

In another example the medical system further comprises a magnetic resonance imaging system. The magnetic resonance imaging system comprises a memory storing machine-executable instructions. The magnetic resonance imaging system further comprises a computational system. Execution of the machine-executable instructions causes the computational system to receive the warning signal from the detection electronics. Execution of the machine-executable instructions further causes the computational system to respond to the warning signal from the detection electronics. In different examples this may take the form of different actions. In one example, an operator warning may be provided. This for example could be in the form of an audio or visual alert which is provided by a system of the magnetic resonance imaging system. In other examples, a user interface on the magnetic resonance imaging system could provide a popup or warning graphical user interface. In another example, in response to the warning signal a warning to a remote service center is provided. This for example could be a service center or location which is monitoring the health and performance of the magnetic resonance imaging system remotely. In some examples it may even cause the remote service center to automatically send a replacement flexible magnetic resonance imaging coil when the warning signal is received. In a further example it may disable the acquisition of k-space data using the flexible magnetic resonance imaging system if the warning signal is received. For example, if there is major damage to the flexible magnetic resonance imaging coil this may cause a situation which may result in the magnetic resonance imaging system not functioning properly. The warning signal could be used to avoid such a situation.

In another example the bend sensor is configured to provide flexion data descriptive of a bending condition of the bend sensor system. The detection electronics are configured to continuously monitor the flexion data to detect the over-flexion condition. For example, sensors might be used which measure the amount or presence of bending of the flexible magnetic resonance imaging coil. In some examples there may be a battery used to power the detection electronics.

In another example the bend sensor comprises a piezo electric bend sensor system. As the bend sensor system is bent there may be signals from individual piezo electric elements that indicate that bending has taken place. For example the voltage signal generated may also be indicative of how much or the degree of the bending. The detection electronics in this case may be configured to continuously monitor these voltages to detect the over-flexion condition and, in some cases, overall wear and tear to the flexible magnetic resonance imaging coil.

In another example the bend sensor system comprises a piezo resistive sensor system. Likewise, the detection electronics may be configured to continuously monitor changes in the resistance of the piezo resistive sensor system. In some instances the piezo resistive sensor may be referred to as a Velostat.

In another example the bend sensor comprises at least one capacitive bend sensor formed from two conductors separated by a compressible dielectric. This example may be beneficial because they provide for a means a robust and reusable bend sensor.

In another example the bend sensor is configured to detect the over-flexion condition when mechanical changed at least a portion of the bend sensor system. This example may be beneficial because it may provide for a means of detecting the over-flexion condition even if the bend sensor system is not powered.

In another example the bend sensor system comprises a fiber optic or light guide bend sensor configured to degrade when bent over a predetermined threshold. For example if the fiber optic or light guide is bent too much then this may cause the fiber optic or light guide to break or have its optical properties degrade.

In another example the bend sensor further comprises a wire configured to break when bent over the predetermined threshold. For example, the wire could be constructed such that if it is bent too much the wire physically breaks. For example, a wire could be made from a brittle material then when bent too much or too high an amount it causes the wire to fail.

In another example the bend sensor is an aluminized glass stick configured to break when bent over the predetermined threshold. The aluminized surface on the glass stick may for example be useful for reflecting light back into it the same way a light guide or fiber optic may function. The glass can have its thickness chosen such that when it is bent beyond the predetermined threshold it breaks.

In another example the bend sensor comprises an elongated cavity filled with a conductive fluid that is configured to leak the conductive fluid when bent over the predetermined threshold. For example, if the elongated cavity is bent too much it may leak and when the conductive fluid is leaked out then an electric circuit may for example be broken.

In another example the bend sensor is attached to the substrate.

In another example the substrate is a composite material.

In another example the substrate is a fabric substrate.

In another example the substrate is a flexible printed circuit board.

In another example the substrate is a plastic substrate.

In another example the substrate is a Teflon substrate. The Teflon substrate may be beneficial because the Teflon may provide for a superior dielectric to isolate the subject from the at least one flexible coil element.

In another example the flexible coil element is formed from a conductive ink.

In another example the at least one flexible coil element is formed from a conductive liquid in an elongated tube.

In another example the at least one flexible coil element is formed from multiple coil element portions moveably attached together.

In another example the at least one flexible coil element is formed from a flexible coaxial cable.

In another example the at least one flexible coil element is formed from a twisted pair cable.

In another example the at least one flexible coil element is formed from multiple wire strands woven into a fabric substrate.

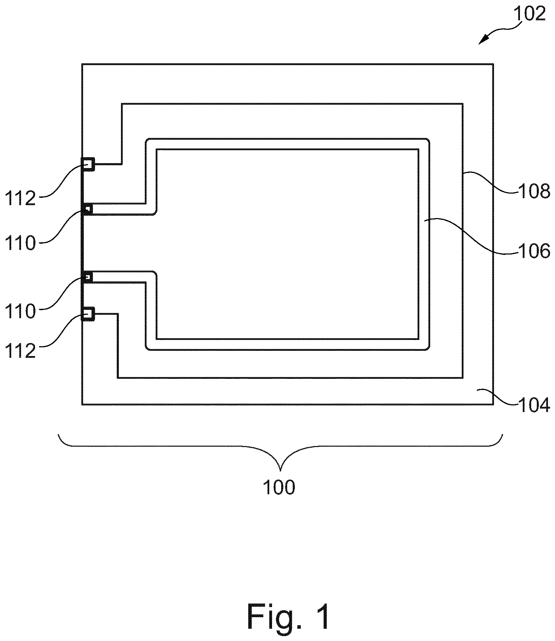

Fig. 1 illustrates an example of the medical system 100 that comprises a flexible magnetic resonance imaging coil 102. The flexible magnetic resonance imaging coil 102 in this example may be an analogue magnetic resonance imaging coil. The flexible magnetic resonance imaging coil 102 comprises a flexible substrate 104 which supports a flexible coil element 106. Surrounding the flexible coil element 106 is a bend sensor 108. As the flexible substrate 104 and the flexible coil element 106 are bent or flexed the bend sensor system 108 detects this. This is an analogue coil 102 so there are individual connectors for the flexible coil element 110 to connect them to a transmitter and/or receiver. There are additional connectors for the bend sensor system 112 which may be used to connect it to a detection electronics 204. The detection electronics 204 could for example be present in a connector for the flexible magnetic resonance imaging coil 102 or they could be located remotely in the vicinity of a transmitter and/or receiver. In this example the flexible magnetic resonance imaging coil 102 is shown as only containing a single flexible coil element 106. However, multiple flexible coil elements 106 could be mounted on the flexible substrate 104.

The bend sensor system 108 could be constructed in different ways. In some examples the entire structure 108 may be of a single sensor. For example, 108 may be a fiber optic or light guide-based sensor that degrades when bent over a predetermined threshold. Likewise, the bend sensor system 108 could be formed from a wire configured to break when bent over the predetermined threshold, an aluminized glass stick configured to break when bent over the predetermined threshold, and also an elongated cavity filled with conductive fluid and configured to leak the conductive fluid when bent over the predetermined threshold. The bend sensor system 108 could for example be attached to the surface of the substrate 104 or it could also be embedded within the substrate 104.

In other examples, the bend sensor system 108 may comprise multiple bend sensors or detectors located at multiple positions along the path defined by 108. For example, the bend sensor system may comprise multiple sensors that are formed as piezoelectric sensors or piezo resistive sensors. In other examples, the bend sensor system may comprise multiple sensors formed by capacitive sensors.

The flexible coil element 106 may be formed in different ways. In one example it is a conductive ink that is printed onto the flexible substrate 104. In other examples it may be a conductive liquid in an elongated tube. In yet other examples the flexible coil element may be multiple coil element portions moveably attached together. In another example, the at least one flexible coil element is formed from flexible coaxial cable.

In another example the flexible coil element is formed from a twisted pair cable. In another example the flexible coil element is formed from multiple wire strands woven into a fabric substrate.

The flexible substrate 104 may be formed in different ways. It may for example be a fabric substrate, a flexibly printed circuit board, a plastic substrate, and a Teflon substrate.

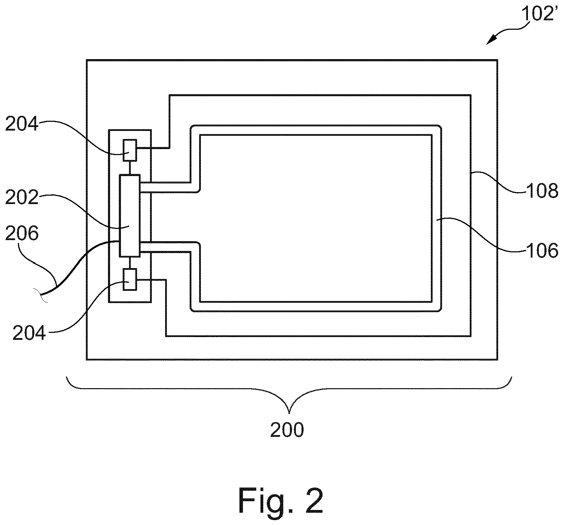

Fig. 2 illustrates a further example of the medical system 200. The medical system 200 comprises a flexible magnetic resonance imaging coil 102' that is digital. The flexible magnetic resonance imaging coil 102' depicted in Fig. 2 is similar to the flexible magnetic resonance imaging coil 102 depicted in Fig. 1. The coil in Fig. 2 additionally comprises digital coil electronics 202 that are connected to the flexible coil element 106. The bend sensor system 108 is shown as being connected to detection electronics 204. The detection electronics 204 may be used to detect the over-flexion condition using the bend sensor system 108. The digital coil electronics 202 may comprise a communication module which now enables a fiber optic communication 206 between the digital coil electronics 202 and a magnetic resonance imaging system. The fiber optic communication 206 may for example be used to transmit a warning signal if the detection electronics 204 detect the over-flexion condition.

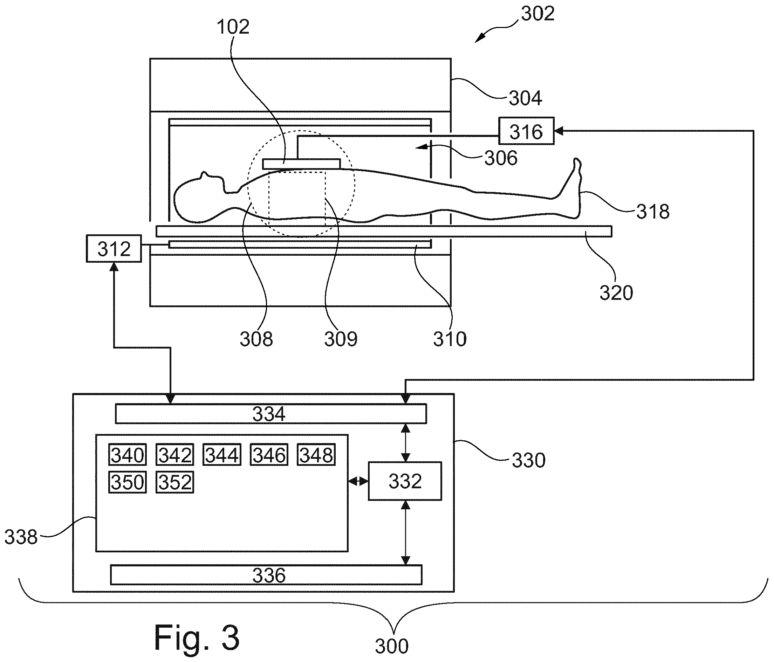

Fig. 3 illustrates a further example of the medical system 300. The medical system 300 is shown as comprising additionally a magnetic resonance imaging system 300 and a computer 330.

The magnetic resonance imaging system 302 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data are acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a flexible coil 102 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The flexible coil 102 is connected to a radio frequency transceiver 316. The radio frequency coil 314 and radio frequency transceiver 316 may be replaced by separate transmit and receive coils and a separate transmitter and receiver. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receiver. The radio frequency coil 314 may also have multiple receive/transmit elements and the radio frequency transceiver 316 may have multiple receive/transmit channels. In some examples the flexible coil 102 is replaced with the flexible coil 102' and the transceiver 316 is replaced by an interface for the fiber optic cable 206.

The magnetic field gradient coil power supply 312 and the transceiver 316 are shown as being connected to a hardware interface 334 of computer system 330. The computer 330 is intended to represent one or more computing systems. The computer 330 is further shown as containing a computational system 332 that is in communication with the hardware interface 334, an optional user interface 336, and a memory 338. The computational system 332 is intended to represent one or more computational systems at one or more locations. The memory 338 is intended to represent various types of volatile and non-volatile memory 338 that are accessible to the computational system 332. In some examples, the memory 338 is a non-transitory storage medium.

The memory 338 is shown as containing machine-executable instructions 340. The machine-executable instructions 340 enable the computational system 332 to perform such tasks as controlling the magnetic resonance imaging system 302 as well as performing basic numerical and data and image manipulation tasks. The memory 338 is further shown as containing pulse sequence commands 342 that enable the computational system 332 to control the magnetic resonance imaging system to acquire k-space data according to a magnetic resonance imaging protocol. The pulse sequence commands 342 may either be commands or data which may be converted into such commands for controlling the magnetic resonance imaging system 302.

The memory 338 is further shown as containing k-space data 344 that was acquired by controlling the magnetic resonance imaging system 302 with the pulse sequence commands 342. The memory 338 is further shown as containing a magnetic resonance image 346 that was reconstructed from the k-space data 344.

In some instances the computational system 332 may have received a warning signal 348 from the magnetic resonance imaging coil 102 or 102'. The warning signal 348 is shown as being stored in the memory 338. When the warning signal 348 is received it may cause the machine-executable instructions 340 to perform a variety of tasks. For example, it may construct a rendering of a operator warning message 350 which may be presented to the user using the user interface 336. In some instances the warning signal 348 may cause the machine-executable instructions 340 to cause the computational system 332 to construct a message to a remote service center 352. In other examples reception of the warning signal 348 may suspend execution of the pulse sequence commands 342.

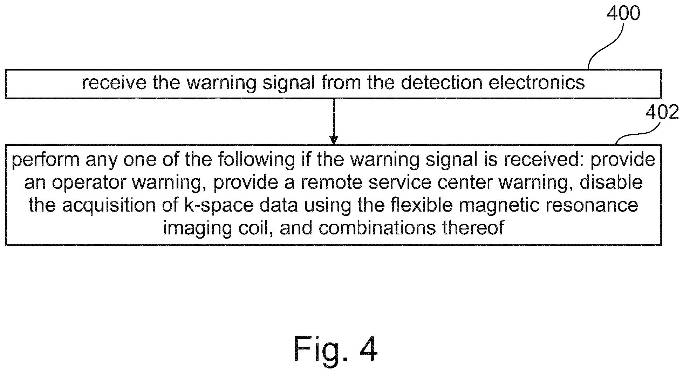

Fig. 4 shows a flowchart which illustrates a method of operating the medical system 300 of Fig. 3. First, in step 400, the warning signal 348 is received from the detection electronics 204. In step 402, any one of the following tasks is performed if the warning signal 348 is received. These tasks include providing an operator warning 350, disable acquisition of the k-space data and providing a remote service center warning 352.

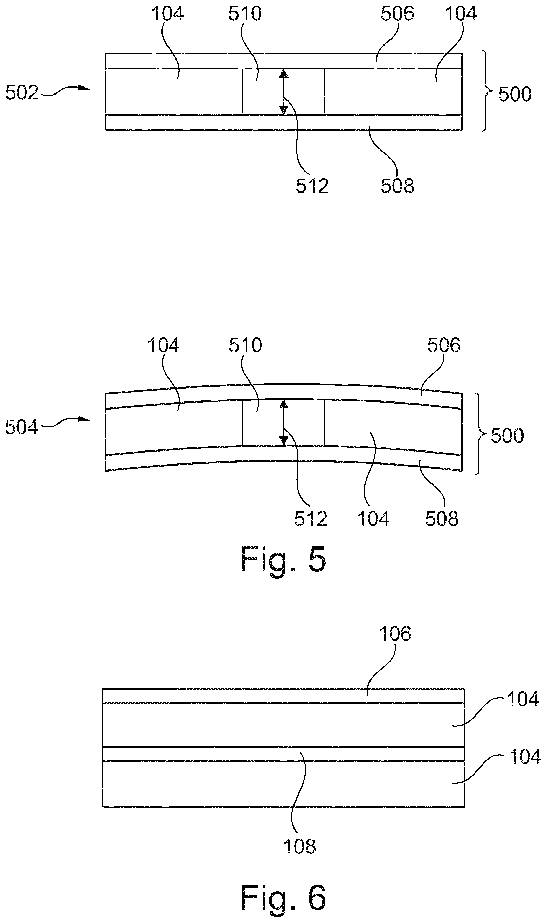

Fig. 5 illustrates an example of a capacitive bend sensor 500. The capacitive bend sensor 500 is shown in two views, there is a straight view 502, where the capacitive bend sensor 500 is in a straightened condition and there is a bent view 504 where the capacitive bend sensor 500 has been bent. The capacitive bend sensor 500 comprises a first electrode 506 and a second electrode 508 that are mounted on opposing surfaces of the flexible substrate 104. At the location of the sensor there is a compressible dielectric 510. In the bent view 504 the distance between electrodes 512 is slightly smaller than in the straight view 502. This causes the capacitance between the first electrode 506 and the second electrode 508 to change. The detection electronics may therefore be a capacitance detector.

Fig. 6 illustrates a further example of the bend sensor 108 being integrated into the flexible magnetic resonance imaging coil 102, 102'. In this example the bend sensor 108 is embedded within the flexible substrate 104. The flexible coil element 106 is mounted above the bend sensor system 108. This example may be particularly useful if the bend sensor 108 is a fiber optic or a light guide that undergoes a physical change if the bend sensor 108 is bent too much. The bend sensor 108 can be shaped to follow the path of the flexible coil element 106 directly and may therefore provide an extremely accurate measurement if the flexible coil element 106 has been over bent or over flexed and put into the over-flexion condition.

It is understood that one or more of the aforementioned embodiments or examples of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan.

A Magnetic Resonance Imaging (MRI) image or MR image is defined herein as being the reconstructed two- or three-dimensional visualization of anatomic data contained within the magnetic resonance imaging data. This visualization can be performed using a computer.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: flexible magnetic resonance imaging coil (analog)
- 102': flexible magnetic resonance imaging coil (digital)
- 104: flexible substrate
- 106: flexible coil element
- 108: bend sensor system
- 110: connections for flexible coil element
- 112: connections for bend sensor system
- 200: medical system
- 202: digital coil electronics
- 204: detection electronics
- 206: fiber optic connection
- 300: medical system
- 302: magnetic resonance imaging system
- 304: magnet
- 306: bore of magnet
- 308: imaging zone
- 309: field of view
- 310: magnetic field gradient coils
- 312: magnetic field gradient coil power supply
- 314: radio frequency coil
- 316: transceiver
- 318: subject
- 320: subject support
- 330: computer
- 332: computational system
- 334: hardware interface
- 336: user interface
- 338: memory
- 340: machine executable instructions
- 342: pulse sequence commands
- 344: measured k-space data
- 346: magnetic resonance image
- 348: warning signal
- 350: rendering of operator warning message
- 352: warning message to remote service center

- 400: receive the warning signal from the detection electronics
- 402: perform any one of the following if the warning signal is received: provide an operator warning, provide a remote service center warning, disable the acquisition of k-space data using the flexible magnetic resonance imaging coil, and combinations thereof
- 500: capacitive bend sensor
- 502: straight view
- 504: bent view
- 506: first electrode
- 508: second electrode
- 510: compressible dielectric
- 512: distance between electrodes

## Claims

1. A medical system (100, 200, 300) comprising a flexible magnetic resonance imaging coil (102, 102'), wherein the flexible magnetic resonance imaging coil comprises:
- at least one flexible coil element (106);
- a flexible substrate (104), wherein the at least one flexible coil element is attached to the flexible substrate; and
- a bend sensor system (108) attached to the flexible substrate and configured to detect an over flexion condition of at least a portion of the at least one flexible coil element.

2. The medical system of claim 1, wherein the medical system further comprises detection electronics, wherein the detection electronics are configured to:
- detect (400) the over flexion condition using the bend sensor system; and
- provide (402) a warning signal (348) if the over flexion condition is detected.

3. The medical system of claim 2, wherein the medical system further comprises a magnetic resonance imaging system (302), wherein the magnetic resonance imaging system comprises a memory (338) storing machine executable instructions (340), wherein the magnetic resonance imaging system further comprises a computational system (332), wherein execution of the machine executable instructions causes the computational system to:
- receive (400) the warning signal from the detection electronics;
- perform (402) any one of the following if the warning signal is received: provide an operator warning, provide a remote service center warning, disable the acquisition of k-space data using the flexible magnetic resonance imaging coil, and combinations thereof.

4. The medical system of claim 2 or 3, wherein the bend sensor system is configured to provide flexion data descriptive of a bending condition of the bend sensor system, wherein the detection electronics are configured to continuously monitor the flexion data to detect the over flexion condition.

5. The medical system of claim 4, wherein the bend sensor system comprises a piezo electric bend sensor system or a piezo resistive sensor system.

6. The medical system of claim 4, wherein the bend sensor system comprises at least one capacitive bend sensor (500) formed from two conductors (506, 508) separated by a compressible dielectric (510).

7. The medical system of claim 1, 2, or 3, wherein the bend sensor system is configured to detect the over flexion condition by a mechanical change to at least a portion of the bend sensor system.

8. The medical system of claim 1, 2, 3, or 7, wherein the bend sensor system comprises any one of the following:
- a fiber optic or light guide bend sensor configured to degrade when bent over a predetermined threshold;
- a wire configured to break when bent over the predetermined threshold;
- an aluminized glass stick configured to break when bent over the predetermined threshold; and
- an elongated cavity filled with a conductive fluid and configured to leak the conductive fluid when bend over the predetermined threshold.

9. The medical system of any one of the preceding claims, wherein the bend sensor is attached to the substrate.

10. The medical system of any one of the preceding claims, wherein the bend sensor is imbedded in the substrate.

11. The medical system of any one of the preceding claims, wherein the substrate is a composite material.

12. The medical system of any one of the preceding claims, wherein the substrate is any one of the following: a fabric substrate, a flexible printed circuit board, a plastic substrate, and a Teflon substrate.

13. The medical system of any one of the preceding claims wherein the at least one flexible coil element is formed from any one of the following:
- a conductive ink;
- a conductive liquid in an elongated tube;
- multiple coil element portions movable attached together;
- flexible coaxial cable;
- twisted pair cable; and
- multiple wire strands woven into a fabric substrate.

14. A method of operating the medical system of any one of claims 2 through 6, wherein the method comprises:
- receiving (400) the warning signal from the detection electronics; and
- performing (402) any one of the following if the warning signal is received: provide an operator warning, provide a remote service center warning, disable the acquisition of k-space data using the flexible magnetic resonance imaging coil, and combinations thereof.

15. A computer program comprising machine executable instructions for execution by a processor controlling the medical system of any one of claims 2 through 6, wherein execution of the machine executable instructions causes the computational system to:
- receive (400) the warning signal from the detection electronics; and
- perform (402) any one of the following if the warning signal is received: provide an operator warning, provide a remote service center warning, disable the acquisition of k-space data using the flexible magnetic resonance imaging coil, and combinations thereof.
